# DEMANDE DE BREVET EUROPEEN

(11) **EP 1 039 546 A1**
(43) Date de publication de la demande: **27.09.2000**
(21) Numéro de dépôt: 00400672.2
(22) Date de dépôt: 10.03.2000
(51) Int. Cl.: H01L 29/06, H01L 29/10, H01L 21/336, H01L 29/78

(54) **Dispositif semi-conducteur à courant de fuite réduit et son procédé de fabrication**

(30) Priorité: 19.03.1999 FR 9903468
(71) Demandeur: FRANCE TELECOM, 75015 Paris (FR)
(72) Inventeur: Stotnicki, Thomas, 38920 Crolles Montfort (FR); Jurczak, Malgorzata, 38000 Grenoble (FR); Gwoziecki, Romain, 38000 Grenoble (FR)
(74) Mandataire: Casalonga, Axel

(57) **Abrégé**

Le dispositif semi-conducteur se caractérise par la présence de cavités isolantes d'air 8, 9 situées dans le canal 6 à proximité des parties inférieures des zones de source 3 et de drain 4, de telle sorte que les courants de fuite sont éliminés dans la partie inférieure du canal 6.

Application aux transistors CMOS.

## Description

La présente invention concerne de manière générale un dispositif semi-conducteur tel qu'un transistor MOS, par exemple un transistor MOS à effet de champ, ayant un comportement amélioré en terme de courant de fuite sous le seuil. L'invention concerne donc plus particulièrement les applications dans le domaine des circuits CMOS de technologie VLSI.

Dans les dispositifs semi-conducteurs tels que les transistors MOS à canaux courts (≤ 0,18 µm), les effets des canaux courts se traduisent par un courant de fuite mal contrôlé par la grille, allant de la région de drain à la région de source.

Afin de contrôler ces courants de fuite, par exemple dans les transistors, les solutions proposées jusqu'à présent consistent, soit à augmenter le taux de dopage du canal, soit l'utilisation de poches ayant un taux de dopage accrû au voisinage des jonctions, soit encore dans le cas où les zones de drain et de source comportent des extensions par une diminution du taux de dopage des extensions.

De telles solutions sont décrites entre autres dans les articles :
- "Characteristics of a Buried-channel Graded drain with punchthrough stopper (BGP) MOS device (Dispositif MOS à caractéristiques de drain étagé à canal enseveli avec stoppeur perçage (BGP)"H. Sunami, K. Shimohigashi et N. Hashimoto, IEEE Trans. Electron Devices, Vol. ED-29, N° 4, pp. 607-610, 1982;
- "High performance dual-gate CMOS utilizing a novel self-aligned pocket implantation (SPI) technology (CMOS double grille à haute performance utilisant une nouvelle technologie (SPI) d'implantation de poches auto-alignées)" A. Hori, M. Segawa, S. Kameyana et M. Yasuhira, IEEE Trans. Electron Devices, Vol. ED-40, N° 9, pp. 1675-1681, 1993; et
- "Study of pocket implant parameters for 0,18 µm CMOS (Etude des paramètres d'implantation de poches pour des CMOS 0,18 µm)" J. Schmitz, Y.V. Ponomarev, A.H. Montree, P.H. Woerlee, ESSDERC'97 Proceedings, pp. 224-227, 1997.

Pour les technologies avancées, la réalisation de poches semble la solution la plus prometteuse, car elle permet de contrôler le courant de fuite, tout en améliorant les caractéristiques d'évolution de la tension de seuil avec la longueur de grille.

La réalisation de ces poches se fait par implantation de dopants de même type que ceux du canal, après réalisation de la grille, et avant ou après la formation des espaceurs.

Toutefois, cette solution présente plusieurs inconvénients. Ces poches sont difficiles à placer à cause de la dispersion des dopants lors de l'implantation et lors des recuits.

L'introduction de telles poches de dopage accrû accroît le dopage du canal et conduit à un effet de substrat plus élevé d'où une perte en courant de saturation.

Le risque d'avalanche est également accrû du fait d'un dopage plus élevé au niveau de la jonction drain/canal.

En outre, les capacités de jonctions sont plus élevées.

Enfin, l'efficacité de telles poches de dopage accrû est modérée dans le cas des dispositifs à canaux courts. Pour accroître l'effet, on pourrait utiliser des poches les plus dopées possibles mais alors au prix d'un accroissement des inconvénients cités précédemment.

L'invention a donc pour objet un dispositif semi-conducteur tel qu'un transistor CMOS, remédiant aux inconvénients ci-dessus.

L'invention a également pour objet un procédé de réalisation d'un tel dispositif.

Selon l'invention, on réalise un dispositif semi-conducteur comprenant un corps en silicium ayant une surface supérieure, des régions de source et de drain formées dans le corps et définissant entre elles une région de canal, une grille formée sur la surface supérieure du corps et alignée avec la région de canal, ledit dispositif semi-conducteur étant caractérisé en ce qu'il comprend, dans la région de canal, au moins une cavité isolante d'une longueur de 5 à 50 nm, de préférence 10 à 20 nm, située à proximité d'une des régions de source ou de drain et à une profondeur par rapport à la surface supérieure telle que ladite cavité isolante empêche le passage de courant allant d'une partie inférieure de la région de drain à une partie inférieure de la région de source.

De préférence, la cavité isolante est adjacente à la région de source et/ou de drain, mieux à la région de drain.

En général, la cavité isolante est située à une profondeur d'au moins 20 nm, et généralement de l'ordre de 40 nm, de la surface supérieure du corps de silicium et la cavité isolante a une épaisseur de 5 à 70 nm, de préférence de 20 à 70 nm.

Dans une réalisation recommandée de l'invention, le dispositif semi-conducteur comprend deux cavités isolantes selon l'invention disposées respectivement à proximité des régions de source et de drain, de préférence adjacentes à ces régions.

Dans une autre réalisation de l'invention, le dispositif comprend au moins deux cavités isolantes disposées l'une au-dessus de l'autre à proximité d'une des régions de source ou de drain ou des deux.

Bien que les cavités isolantes peuvent être remplies d'un matériau isolant solide, de préférence les cavités isolantes sont des cavités d'air.

La réalisation d'au moins une telle cavité isolante selon l'invention, dans un dispositif semi-conducteur, supprime donc les lignes de courant allant de la région de drain à la région de source dans leur partie inférieure tout en laissant subsister les lignes de courant proches de l'interface entre l'oxyde de grille et le corps ou substrat de silicium qui sont sous le contrôle de la polarisation de grille.

La présente invention concerne également un procédé de fabrication d'un dispositif semi-conducteur comportant au moins une cavité isolante pour supprimer le passage de courant entre des parties inférieures d'une région de drain et d'une région de source qui comprend :
- la formation sur un substrat de silicium d'une couche d'un matériau sélectivement éliminable;
- la formation sur la couche de matériau sélectivement éliminable d'une couche de silicium monocristallin;
- la formation sur la couche de silicium d'une couche de diélectrique et d'une grille;
- la gravure le long de deux côtés opposés de la grille d'un évidement pénétrant dans le substrat;
- l'élimination latéralement, depuis au moins l'un des évidements, de la couche de matériau sélectivement éliminable sur une longueur de 5 à 50 nm, de préférence 10 à 20 nm, pour former au moins une poche; et
- le remplissage des évidements pour former des régions de source et de drain, et au moins une cavité isolante d'une longueur de 5 à 50 nm, de préférence de 10 à 20 nm à proximité d'une partie inférieure d'au moins une des régions de source ou de drain ainsi formées.

Dans une réalisation du procédé de l'invention, l'étape d'élimination latérale de la couche de matériau sélectivement éliminable s'effectue depuis les deux évidements sur les côtés opposés de la grille pour former ainsi deux cavités à proximité, respectivement, de parties inférieures de la région de source et de la région de drain.

Dans une autre réalisation du procédé de l'invention, on forme, avant l'étape de gravure, plusieurs couches alternativement superposées de matériau sélectivement éliminable et de silicium monocristallin pour, lors de l'étape d'élimination latérale d'une longueur prédéterminée des couches de matériau sélectivement éliminables, former des poches et finalement des cavités isolantes les unes au-dessus des autres.

De préférence, la ou les cavités isolantes sont des cavités remplies d'air. Toutefois, on peut également réaliser des cavités isolantes remplies d'un matériau solide. Dans ce dernier cas, avant l'étape de remplissage pour former les régions de source et de drain, on procède au dépôt d'une couche de matériau isolant solide remplissant les poches et gravure de la couche avant de former les régions de source et de drain.

De préférence, le matériau sélectivement éliminable est un alliage ou métal semi-conducteur choisi parmi Si₁₋ₓGeₓ (0 < x ≤ 1) et Si₁₋ₓ₋-_{y}GeₓC_{y} (0< x ≤ 0,95 : 0 < y ≤ 0,05). Ces alliages et métaux semi-conducteurs présentent l'avantage d'être aisément sélectivement éliminables au moyen d'une chaîne oxydante, par exemple une solution acide renfermant de l'eau oxygénée ainsi que par une attaque plasma isotrope.

Bien évidemment, les épaisseurs de la ou des couches de matériau sélectivement éliminables sont choisies pour obtenir les épaisseurs voulues des cavités, généralement de 5 à 70 nm, de préférence de 20 à 70 nm.

De même, l'épaisseur de la couche de silicium déposée sur la couche de matériau sélectivement éliminable ou sur la dernière couche de ce matériau, sera d'une épaisseur suffisante pour que la ou les cavités soient situées dans des parties inférieures des régions de source et de drain, généralement d'au moins 20 nm, de préférence de l'ordre de 40 nm.

Il est important pour la couche éliminable qu'elle soit en accord de maille atomique avec le silicium, assurant ainsi la continuité sans défauts de la cristallinité des couches. Ceci assure une bonne mobilité des porteurs dans la couche supérieure de silicium qui constitue par exemple le canal d'un transistor.

La suite de la description se réfère aux figures annexées, qui représentent respectivement :
Figure 1 - une coupe schématique d'une réalisation d'un semi-conducteur selon l'invention;
Figures 2a à 2d - une des vues, en coupe schématique, des principales étapes d'une réalisation d'un procédé de fabrication d'un dispositif semi-conducteur selon l'invention; et
Figure 3 - un graphe du courant de drain en fonction de la tension de grille pour un dispositif semi-conducteur avec cavités isolantes.

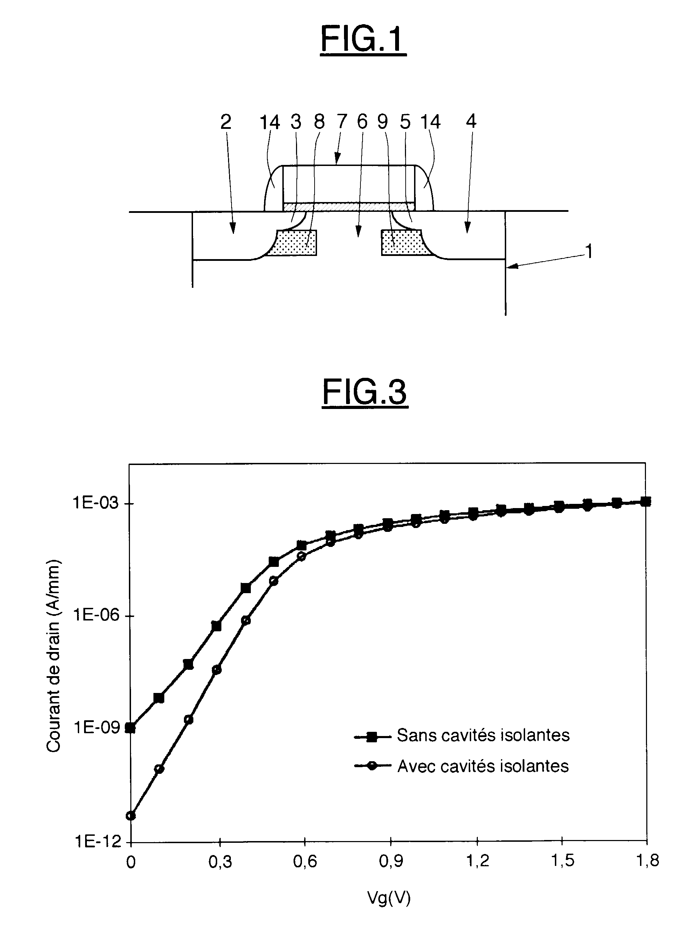

En se référant à la figure 1, on a représenté schématiquement en coupe une réalisation d'un dispositif semi-conducteur selon l'invention.

Comme le montre la figure 1, le dispositif comprend un substrat ou corps 1 en silicium, dans lequel sont formées des régions de source 2 et de drain 4.

Comme cela est classique, les régions de source 2 et de drain 4 peuvent comporter des extensions plus faiblement dopées 3 et 5, respectivement.

Ces régions de source 2 et de drain 4 et leurs extensions respectives 3, 5, définissent entre elles une région de canal 6. Une grille 7 est également formée sur la surface supérieure du corps 1 au-dessus de la région de canal 6 recouvert préalablement d'une couche de diélectrique de grille.

Selon l'invention, le dispositif semi-conducteur comprend, en outre, dans la réalisation représentée, deux cavités isolantes 8, 9, remplies d'air, situées au-dessus de la région de canal 6, respectivement adjacentes aux régions de source et de drain 2, 4, dans une partie inférieure de celles-ci.

Les cavités isolantes 8, 9 ont une longueur de 5 à 50 nm et sont situées en dessous des extensions 3, 5 des régions de source et de drain 2, 4, et généralement à au moins 20 nm ou plus de la surface supérieure du corps 1 en silicium. Les cavités ont une épaisseur en générale de 50 à 70 nm.

Ainsi, les lignes de courant allant du drain 4 à la source 2 dans leurs parties inférieures sont arrêtées par les cavités, cependant que les lignes de courant dans la partie de la région de canal au-dessus des cavités 8, 9, sont contrôlées par la grille 7.

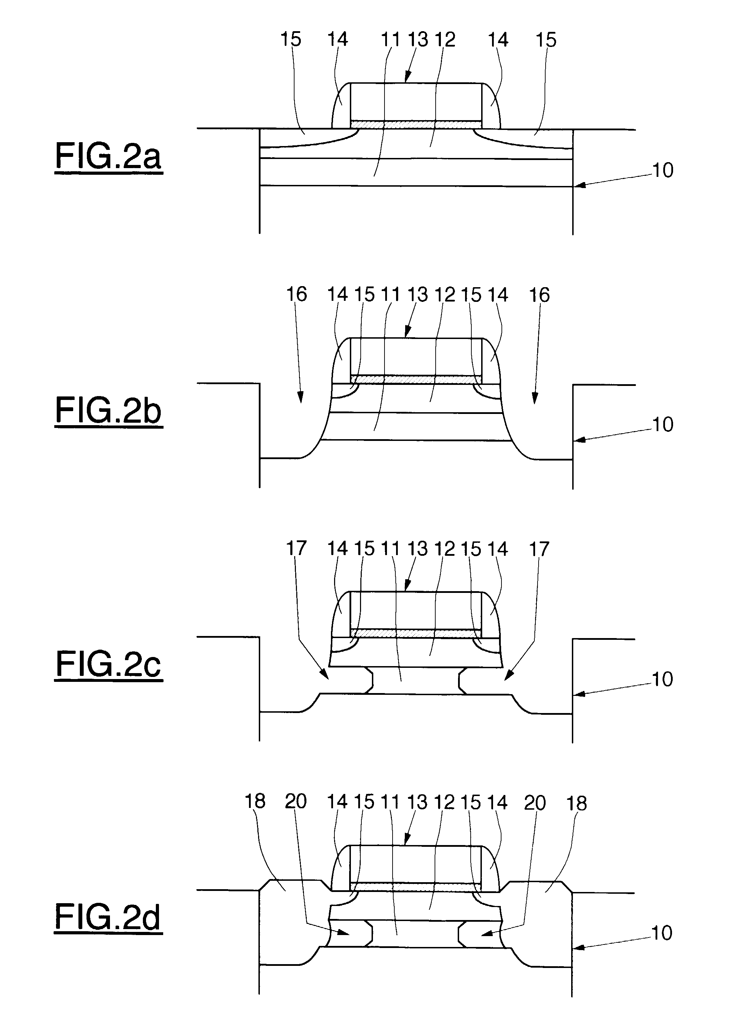

En se référant aux figures 2a à 2d, on va maintenant décrire une mise en oeuvre d'un procédé de fabrication d'un dispositif semi-conducteur selon l'invention.

On réalise de manière classique par épitaxie, comme le montre la figure 2a, sur un substrat 10 de silicium, une couche 11 d'alliage Si₁₋ₓGeₓ d'épaisseur en général 5 à 70 nm, puis sur cette couche d'alliage Si₁₋ₓGeₓ, une couche de silicium monocristallin 12 généralement d'épaisseur d'au moins 20 nm. Sur la couche de silicium, on forme également de manière classique une couche de diélectrique et une grille 13 généralement pourvue d'espaceurs 14. On réalise alors, comme cela est connu, des zones dopées 15 qui servent à former les extensions des régions de source et de drain.

Comme le montre la figure 2b, on grave alors, toujours de manière classique, des évidements 16 sur des côtés opposés de la grille 13, ces évidements 16 s'étendant jusque dans le substrat ou corps en silicium 10. On peut, par exemple, utiliser une gravure à temps fixe, avec une profondeur de l'ordre de 30 à 100 nm.

A ce stade, comme le montre la figure 2c, on procède, selon l'invention, à l'élimination latérale sélective de la couche d'alliage Si₁₋ₓGeₓ, à partir des évidements 16, pour former deux poches opposées 17 d'une profondeur de 5 à 50 nm.

Cette élimination latérale sélective peut par exemple s'effectuer au moyen d'une solution contenant 40 ml HNO₃ (70%), 20 ml H₂O₂ et 5 ml HF (0,5%) qui est sélective par rapport au silicium ou par une attaque plasma isotrope.

A ce stade, on peut, si on le souhaite, remplir les poches 17 avec un matériau diélectrique, mais de préférence on laisse les poches 17 remplies d'air.

Puis on forme, comme le montre la figure 2d, par exemple par épitaxie sélective, les régions de source et de drain 18 et 19 (dopées in situ ou non).

Suivant la distance d'élimination latérale du Si₁₋ₓGeₓ, il se forme alors des cavités isolantes 20, selon l'invention, ayant en général une longueur de 5 à 50 nm.

Afin de ne pas remplir les poches 17 lors de la formation par épitaxie des régions de source et de drain 18, 19, on peut préalablement protéger les poches 17 par la formation d'espaceurs, par exemple en silicium polycristallin.

En procédant comme indiqué ci-dessus, on a simulé la réalisation d'un transistor MOS à dopage canal uniforme faible ayant deux cavités isolantes 20 remplies d'air, adjacentes respectivement aux régions de source et de drain. Chaque cavité isolante avait une longueur de 50 nm, une épaisseur de 60 nm et était située à une profondeur de 40 nm de la surface supérieure du substrat ou corps de silicium 1.

On a mesuré le courant de drain de ce transistor CMOS en fonction de la tension de grille (Vg) et comparé au courant de drain d'un transistor MOS identique mais dépourvu de cavités isolantes.

Les résultats sont représentés à la figure 3.

La figure 3 montre que la réalisation de cavités isolantes selon l'invention permet de réduire fortement le courant de fuite (2 décades de réduction à Vg = 0) et d'améliorer le comportement sous le seuil sans diminution du courant de sortie.

## Revendications

1. Dispositif semi-conducteur comprenant un corps en silicium (1) ayant une surface supérieure, des régions de source (2) et de drain (4) formées dans le corps et définissant entre elles une région de canal (6), une grille (7) formée sur la surface supérieure du corps et alignée avec la région de canal (6), caractérisé en ce qu'il comprend dans la région de canal (6) au moins une cavité isolante (8) d'une longueur de 5 à 50 nm située à proximité d'une des régions de source ou de drain et à une profondeur par rapport à la surface supérieure telle que ladite cavité isolante empêche le passage de courant allant de la partie inférieure de la région de drain à la partie inférieure de la région de source.

2. Dispositif selon la revendication 1, caractérisé en ce que la ou les cavités isolantes (8) sont situées à une profondeur d'au moins 20 nm de la surface supérieure du corps.

3. Dispositif selon la revendication 1 ou 2, caractérisé en ce que la ou les cavités isolantes (8) ont une épaisseur allant de 5 à 70 nm.

4. Dispositif selon l'une quelconque des revendications 1 à 3, caractérisé en ce que la ou les cavités (8) sont adjacentes à la région de source (2) et/ou de drain (4).

5. Dispositif selon l'une quelconque des revendications 1 à 4, caractérisé en ce qu'elle comprend au moins deux cavités isolantes par côté source et drain, l'une au-dessus de l'autre.

6. Dispositif selon l'une quelconque des revendications 1 à 5, caractérisé en ce que la ou les cavités isolantes (8) sont remplies d'air.

7. Dispositif selon l'une quelconque des revendications 1 à 5, caractérisé en ce que la ou les cavités (8) sont remplies d'un matériau diélectrique.

8. Procédé de fabrication d'un dispositif semi-conducteur comportant au moins une cavité isolante (20) supprimant le passage de courant entre des parties inférieures d'une région de drain (19) et d'une région de source (18), caractérisé en ce qu'il comprend :
- la formation sur un substrat de silicium (10) d'une couche (11) d'un matériau sélectivement éliminable ;
- la formation sur la couche de matériau sélectivement éliminable d'une couche de silicium monocristallin (12) ;
- la formation sur la couche de silicium d'une couche de diélectrique et d'une grille (13) ;
- la gravure sur des côtés opposés de la grille d'un évidement (16) pénétrant dans le corps de silicium ;
- l'élimination latéralement, depuis au moins un des évidements, de la couche de matériau sélectivement éliminable sur une longueur allant de 5 à 50 nm pour former au moins une poche (17) ; et
- le remplissage des évidements (16) pour former les régions de source et de drain (18, 19) et au moins une cavité isolante (20) d'une longueur de 5 à 50 nm entre et à proximité d'une partie inférieure d'au moins une des régions de source et de drain.

9. Procédé selon la revendication 8, caractérisé en ce qu'on forme alternativement plusieurs couches de matériau sélectivement éliminable et de silicium monocristallin pour former plusieurs cavités isolantes les unes au-dessus des autres.

10. Procédé selon la revendication 8 ou 9, caractérisé en ce que le matériau sélectivement éliminable est choisi parmi les alliages Si₁₋ₓGeₓ (0 < x ≤ 1) et Si_{1-x-y}GeₓC_{y} (0< x ≤ 0,95 : 0 < y ≤ 0,05).

11. Procédé selon la revendication 10, caractérisé en ce que la ou les couches de matériau sélectivement éliminable assurent une continuité de maille cristalline avec le substrat de silicium.

12. Procédé selon l'une quelconque des revendications 8 à 11, caractérisé en ce que la ou les couches de matériau sélectivement éliminable ont une épaisseur de 5 à 70 nm.

13. Procédé selon l'une quelconque des revendications 8 à 12, caractérisé en ce qu'il comprend après l'étape d'élimination du matériau sélectivement éliminable et avant le remplissage des évidements (16), la formation d'espaceurs obturant la ou les poches (17).

14. Procédé pour supprimer le passage de courant entre des parties inférieures des régions de source et de drain (18, 19) comportant éventuellement des extensions d'un dispositif semi-conducteur, caractérisé en ce qu'il consiste à former dans une région de canal séparant les parties inférieures des régions de source et de drain au moins une cavité isolante (20) ayant une longueur de 5 à 50 nm à proximité de la partie inférieure d'une des régions de source ou de drain ou des extensions.

15. Procédé selon la revendication 14, caractérisé en ce que la cavité isolante (20) est située à proximité de la partie inférieure de la région de drain.

16. Procédé selon la revendication 14, caractérisé en ce qu'on forme une cavité à proximité de chacune des parties inférieures des régions de source et de drain.

17. Procédé selon la revendication 14, caractérisé en ce qu'on forme plusieurs cavités les unes au-dessus des autres à proximité d'au moins une des parties inférieures des régions de source et de drain.

18. Procédé caractérisé en ce que la ou les cavités ont une épaisseur de 5 à 70 µm.
